# EUROPÄISCHE PATENTSCHRIFT

(11) **EP 2 986 169 B1**
(45) Veröffentlichungstag und Bekanntmachung des Hinweises auf die Patenterteilung: **06.02.2019**
(21) Anmeldenummer: 14732497.4
(22) Anmeldetag: 17.04.2014
(51) Int. Cl.: A24C 5/00, B23K 10/00, B23K 103/00, B26F 3/16, A24C 5/56, H01J 37/32

(54) **PLASMAPERFORATION**
PLASMA PERFORATION
PLASMA PERFORATION

(30) Priorität: 19.04.2013 AT 502682013
(43) Veröffentlichungstag der Anmeldung: 24.02.2016
(73) Patentinhaber: Tannpapier GmbH, 4050 Traun (AT)
(72) Erfinder: LINDNER, Michael, 4224 Wartberg ob der Aist (AT)
(74) Vertreter: Burgstaller, Peter
(86) Internationale Anmeldenummer: PCT/AT2014/050096
(87) Internationale Veröffentlichungsnummer: WO 2014/169313

(56) Entgegenhaltungen:
- EP-B1- 0 565 341
- WO-A1-01/83149
- GB-A- 2 055 669
- US-A- 3 475 591
- US-A- 5 092 350
- US-A1- 2005 035 093

## Beschreibung

Die Erfindung betrifft ein Verfahren zur Plasmaperforation von Tippingpapier und eine Vorrichtung zur Plasmaperforation.

Fünf wesentliche Teile einer üblichen Filterzigarette sind der Tabakstrang, das diesen einhüllende Zigarettenpapier, der Filter, das Filterhüllpapier und das Tippingpapier (Mundstückbelagspapier) .

Das Mundstückbelagspapier, oft auch als "Tippingpapier" oder kurz "Tipping" bezeichnet, umhüllt den Filter und das Filterhüllpapier. Es ist jener Teil der Filterzigarette, welcher beim Rauchen der Filterzigarette durch die Lippen der die Zigarette rauchenden Person berührt wird. In der Regel ragt das Tippingpapier in Längsrichtung der Filterzigarette auch geringfügig in den Längsbereich des Tabakstranges, umhüllt dort das Zigarettenpapier und ist mit diesem durch eine Klebung verbunden. Durch das Herstellen dieser Klebung werden in der Zigarettenmaschine Filterteil und Tabakstrangteil mechanisch verbunden. Das Tippingpapier ist zumeist tatsächlich ein Papier, es kann beispielsweise ein Film oder eine Folie sein. Im Fall der Ausbildung des Tippingpapiers als Film oder Folie kann es beispielsweise aus Cellulosehydrat bestehen.

Üblicherweise weist das Tippingpapier eine optisch ansprechende Bedruckung auf. Oftmals erinnert diese Bedruckung an Kork.

Am tabakstrangnahen Ende ist das Tippingpapier üblicherweise zum Teil perforiert ausgeführt, sodass beim Saugen an der Zigarette Luft aus der Umgebung in den Filter gelangt und sich dort mit dem aus dem Tabakstrang kommenden Rauchstrom vermengt, wodurch die Rauchwerte vorteilhaft verändert werden.

Das Tippingpapier wird in der Regel nach dem Bedrucken perforiert um zu verhindern, dass die Perforationslöcher durch das Bedrucken wieder verschlossen werden.

Zur Perforation von Papier, Papierbahnen oder anderen Materialien kommen gemäß dem Stand der Technik drei Verfahren zum Einsatz.
- Mechanische Perforation
- Laserperforation
- Elektroperforation

Bei der mechanischen Perforation kommen spitze Nadeln oder Nadelkissen zum Einsatz, welche das Tippingpapier durchstechen. Ein solches Verfahren wird in der EP 0222973 A1 zur Perforation des Filterhüllpapiers beschrieben. Der mittlere Durchmesser der Luftdurchgangsöffnungen (Lochgröße) beträgt bei dieser Methode zwischen etwa 0,05 bis etwa 0,4 mm. Nachteilig ist, dass die Nadeln einer mechanischen Abnutzung unterliegen und daher die Lochgröße Schwankungen unterliegt, bzw. die Nadeln häufig getauscht werden müssten um konstante Lochgrößen zu erzielen.

Bei der Laserperforation wird das Papier durch einen gebündelten Lichtstrahl perforiert. Ein solches Verfahren wird beispielsweise in der DE2751522 A1 und in der DE 102004001327 A1 beschrieben. Die Lochgröße entspricht etwa der der mechanischen Perforation, es können also Löcher ab einem Durchmesser von 0,05mm hergestellt werden. Vorteilhaft gegenüber der mechanischen Perforation ist, dass keine Abnutzung der Vorrichtung stattfindet und die Lochdurchmesser und Lochpositionen sehr genau eingestellt werden können. Nachteilig ist, dass keine Löcher mit Durchmesser unter 0,05 mm hergestellt werden können.

Bei der Elektroperforation, auch elektrostatische Perforation genannt, wird das Papier durch Verbrennung perforiert, indem ein elektrischer Funkenschlag durch das Papier erfolgt. Dabei kommen nadelförmige Elektroden zum Einsatz, welche an einer Seite der Papierbahn angeordnet sind. An der anderen Seite befindet sich eine flächige Gegenelektrode, oder wiederum mehrere Nadelelektroden. Die Nadelelektroden und die Gegenelektroden sind durch die Papierbahn und einen schmalen Luftspalt getrennt. Durch Anlegen einer Hochspannung an den Elektroden kommt es zur Entladung durch den Luftspalt und die Papierbahn. Durch die hohe thermische Energie des Funkenüberschlags verbrennt die Papierbahn kleinflächig und es bildet sich ein Loch. Vorteilhaft ist, dass sehr kleine Löcher, mit einem Durchmesser von 0,01 mm hergestellt werden können. Nachteilig ist, dass durch die Verbrennung sichtbare Spuren an den Lochrändern auftreten (Brandränder), dass durch die schwer zu kontrollierende Entladung die Lochgrößenverteilung stark streut und dass durch Kriechentladungen sogenannte Funkenspritzer auftreten die zusätzlich kleinste Löcher rund um die gewünschten Perforationslöcher bewirken. Beispiele für die Elektroperforation werden in der DE3016622 (A1), der US4094324 (A) und in der DE2934045 (A1) gezeigt.

Die EP 0565341 A2 zeigt ein Verfahren zum Herstellen von Löchern in einem Substrat. Dabei werden die Ränder eines gebohrten Lochs durch Plasmaentladung bearbeitet. Die Plasmaentladung erfolgt in einem geschlossenen Arbeitsbereich mit einer definierten Atmosphäre, wobei im gesamten Arbeitsbereich dieselbe Gaszusammensetzung vorliegt.

Ferner zeigen die EP 025776 A2, die WO 0183149 A1 und die US 20050035093 A Plasmaschneider. Bei Plasmaschneidern wird ein Plasmagasstrahl, also ein hochenergetischer Strahl aus ionisiertem Gas, gegen das zu schneidende Werkstück gerichtet.

Die der Erfindung zu Grunde liegende Aufgabe besteht darin, ein Verfahren zu schaffen, dass in der Lage ist kleine Lochgrößen ab 0,01 mm in Tippingpapier herzustellen unter Vermeidung der Nachteile der Elektroperforation.

Für das Lösen der Aufgabe wird ein Verfahren gemäß Anspruch 1 zur Plasmaperforation von Tippingpapier vorgeschlagen, bei welchem an der Oberfläche des Tippingpapiers ein Niedertemperaturplasma erzeugt wird, indem ein ionisierbares Gasgemisch durch eine möglichst punktförmige Energiequelle kurzzeitig ionisiert wird, wobei ein unter Druck stehendes Inertgas oder ein Gasgemisch mit hoher Inertgaskonzentration, ringförmig um die Energiequelle in Richtung des Tippingpapiers eingebracht wird, wodurch das ionisierbare Gasgemisch auf einen sehr kleinen Oberflächenbereich des Tippingpapiers vor der Energiequelle örtlich beschränkt wird, indem dieser Bereich von einem Gasgemisch mit höherer Inertgaskonzentration ringförmig umgeben wird.

Zur Lösung der oben genannten Aufgabe wird weiterhin im Anspruch 5 eine Vorrichtung zur Plasmaperforation von Tippingpapier definiert.

Die Herausforderung der gegenständlichen Erfindung ist es, ein kontrolliertes, reproduzierbares Niedertemperaturplasma zu erzeugen, da nur so erreicht werden kann, dass eine exakte Lochgröße und Lochposition im Tippingpapier erzeugt wird. Plasma wird durch Ionisierung eines Gases oder Gasgemisches erzeugt. Für den Ionisierungsgrad und die Plasmatemperatur ist neben der zugeführten Energie und dem herrschenden Druck besonders das Gas bzw. die Zusammensetzung des ionisierten Gasgemisches entscheidend.

Wird ein Feststoff in Kontakt mit dem Niedertemperaturplasma gebracht kommt es an seiner Oberfläche zu zwei Effekten, nämlich Sublimation und Oxidation. Sublimation ist der direkte Übergang von Materie vom festen Zustand in den gasförmigen. Oxidation ist eine chemische Reaktion unter Elektronenabgabe eines chemischen Stoffes. Die Oxidation eines chemischen Stoffes mit Sauerstoff kann bei Flammbildung als Verbrennung beobachtet werden. Durch die Oxidation werden die Ausgangstoffe verändert und neue chemische Verbindungen geschaffen.

Wird das Niedertemperaturplasma im Gasgemisch angrenzend an die Oberfläche von Tippingpapier erzeugt, so kommt es durch die beiden genannten Effekte dazu, dass sich im Bereich des Niedertemperaturplasmas ein Loch bildet. Dabei ist der Effekt der Sublimation dem Effekt der Oxidation (Verbrennung) vorzuziehen, da die Oxidation zu unerwünschten Verbrennungsprodukten führen kann, die je nach Zusammensetzung der Ausgangsstoffe auch toxische Wirkung haben können. Verbrennungsprodukte können sichtbar sein in Form von Verbrennungsrückständen, welche den optischen Eindruck schmälern und unter Umständen den Geschmack einer Zigarette verändern können. Bei der Sublimation verdampfen die Feststoffe des Tippingpapiers rückstandslos. Daher wird bei der gegenständlichen Erfindung ein Niedertemperaturplasma erzeugt und dessen Eigenschaften so gesteuert, dass fast ausschließlich der Vorgang der Sublimation stattfindet.

Technisch wird dies umgesetzt indem an einem lokal begrenzten Oberflächenbereich des Tippingpapiers ein definiertes Gasgemisch oder ein bestimmtes Gas eingebracht wird und dieses Gas durch eine zeitlich begrenzte, gebündelte Zufuhr von Energie ionisiert wird. Dadurch dass das Gasgemisch und die zugeführte Energie nur lokal in einem sehr begrenzten Bereich aufeinander treffen, wird erreicht, dass das Niedertemperaturplasma nur in diesem kleinen Bereich erzeugt wird und daher nur mit einem sehr kleinen Bereich der Oberfläche des Tippingpapiers in Berührung kommt. Daraus resultieren eine kleine Lochgröße und eine hohe Positionsgenauigkeit des Lochs.

Die gegenständliche Erfindung ist gegenüber dem Stand der Technik vorteilhaft, weil gegenüber der Laserperforation und der mechanischen Perforation sehr kleine Lochdurchmesser erzielt werden können und weil gegenüber der elektrischen Perforation eine sehr exakte Lochgröße und exakte Lochposition erzielt werden kann. Vorteilhaft gegenüber der Elektroperforation ist zusätzlich, dass Verbrennungsspuren an den Lochrändern sichtbar vermieden werden.

Die Erfindung wird an Hand von Zeichnungen veranschaulicht:
- Fig. 1:: Zeigt ein Beispiel für eine erfindungsgemäße Vorrichtung in Schnittansicht.
- Fig. 2:: zeigt ein zweites Beispiel einer erfindungsgemäßen Vorrichtung in Schnittansicht.
- Fig. 3:: Zeigt ein Beispiel einer erfindungsgemäßen Vorrichtung bei der ein Laserstrahl als Energiequelle dient.

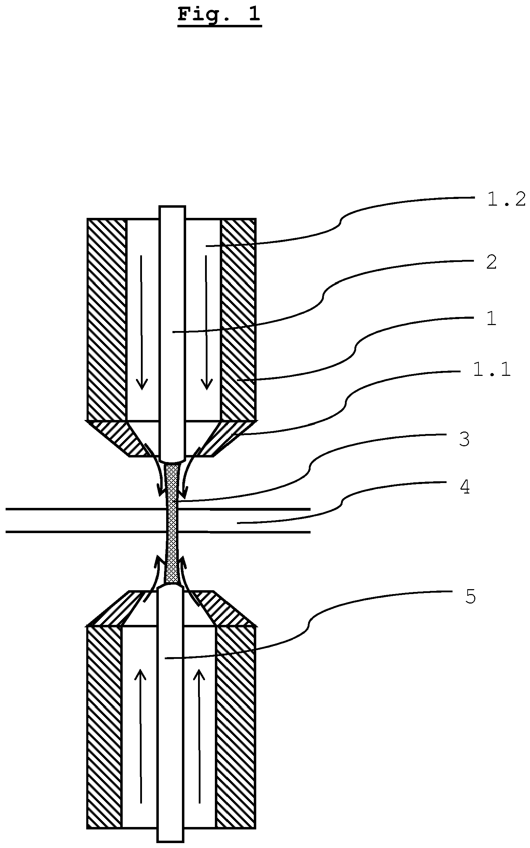

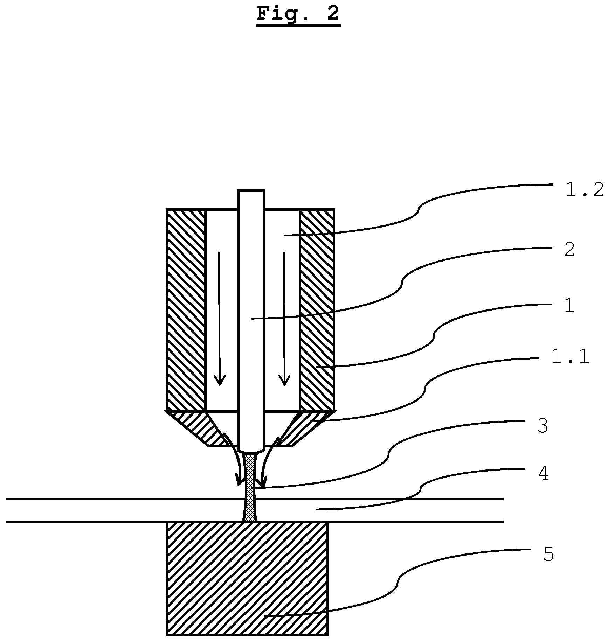

In Fig. 1 ist eine erfindungsgemäße Vorrichtung zur Plasmaperforation einer Papierbahn, insbesondere einer Tippingpapierbahn oder eines Tippingpapiers 4 dargestellt. An zumindest einer flächigen Seite des Tippingpapiers 4 ist eine möglichst kleinflächige Energiequelle angeordnet. In diesem Beispiel wird als Energiequelle eine nadelförmige Elektrode 2 verwendet, genauer gesagt das Anlegen einer Spannung zwischen zwei Elektroden 2, 5. Die Elektrode 2 ist in einem Rohr 1 angebracht. Das Rohr 1 dient zum Transport eines unter Druck stehenden Gases oder Gasgemisches. Zum besseren Verständnis wird der Gasstrom in den Figuren durch Pfeile veranschaulicht. Am vorderen Ende des Rohrs 1 befindet sich eine Düse 1.1 zur Verengung des Gasstroms. Diese Düse 1.1 ist konzentrisch um die Elektrode 2 im Bereich ihrer dem Tippingpapier 4 zugewandten Spitze angebracht. Durch den vom Rohr 1 und der Düse 1.1 eingeschlossenen Hohlraum 1.2 wird also ein unter Druck stehendes Gas oder Gasgemisch ringförmig um die Elektrode 2 in Richtung des Tippingpapiers 4 eingebracht. An der anderen Seite des Tippingpapiers 4 kann sich eine ebenso ausgeführte nadelförmige Gegenelektrode 5 befinden oder wie in Fig. 2 gezeigt eine flächige Gegenelektrode 5.

Indem durch den Hohlraum 1.2 ein inertes Gas oder ein Gasgemisch mit hoher Inertgaskonzentration eingebracht wird, verbleibt in der Mitte dieses Gasstroms, also direkt vor der Spitze der Elektrode 2 zum Tippingpapier 4 ein schmaler Bereich mit einer anderen Gaszusammensetzung. In diesem Bereich ist die Konzentration von Inertgas etwas geringer als im direkten Strom aus der Düse 1.1. Dadurch ist es leichter möglich in diesem Bereich das Gas zu ionisieren und so ein lokal begrenztes Plasma 3 zu erzeugen, welches schließlich durch Sublimation ein Loch im Tippingpapier 4 erzeugt. Da schon im und vor allem um das Plasma 3 eine hohe Konzentration an Inertgas vorhanden ist, wird die Oxidation an der Oberfläche des Tippingpapiers 4 unterbunden, wodurch Brandspuren am Rand des Loches sichtbar vermieden werden. Durch eine enge oder etwas weitere Ausgestaltung der Düse 1.1 oder durch Veränderung des Abstands mit welchem die Elektrode 2 aus der Düse 1.1 ragt kann die Ausdehnung des Bereichs mit niedrigerer Inertgaskonzentration und somit des Plasmas 3 vergrößert oder verringert werden. Die bestmögliche Ausgestaltung der Vorrichtung sowie das ideale Inertgas oder Gasgemisch ist am besten durch Versuch zu ermitteln, da diese von der Beschaffenheit des zu perforierenden Materials insbesondere Tippingpapiers 4 abhängen.

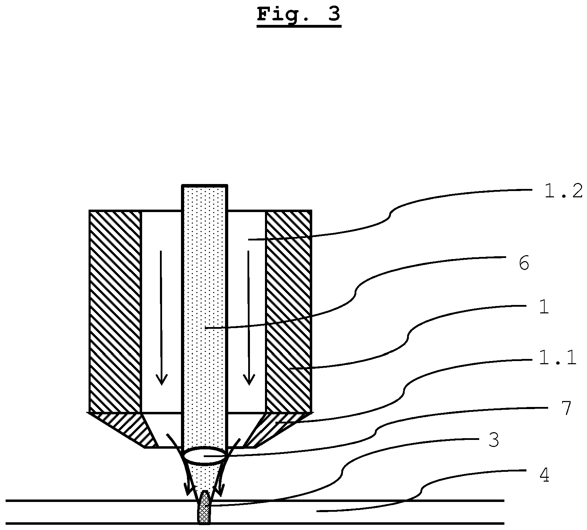

Fig. 3 zeigt das erfindungsgemäße Verfahren mit einem Laserstrahl 6 als Energiequelle. Am unteren Ende des Rohres 1 ist wiederum eine Düse 1.1 angeordnet. In dieser Düse befindet sich mittig eine Linse 7, welche zwei Aufgaben erfüllt. Die Linse 7 dient erstens zur Fokussierung des Laserstrahls 6 auf die Oberfläche des Tippingpapiers. Zweitens dient die Linse 7 dazu den Gasstrom aus der Düse 1.1 in gewünschter Weise zu beeinflussen und zwar derart, dass der Gasstrom ringförmig um die Linse 7 erfolgt. Damit das Inertgas oder Gasgemisch rund um die Linse 7 ausströmen kann, ist diese beispielsweise mit dünnen Drähten im Rohr 1 fixiert, oder befindet sich am Ende eines starren Lichtwellenleiters der wie die Elektrode 2 senkrecht im Rohr 1 verläuft. Das Plasma 3 beschränkt sich in diesem Fall auf den Bereich, indem die Energiedichte des Laserstrahls 6 hoch genug ist, um das Gasgemisch mit einer ausreichend geringen Inertgaskonzentration zu ionisieren. Im Brennpunkt der Linse 7 ist die Energiedichte des Laserstrahls 6 am höchsten und auch die Inertgaskonzentration am geringsten, daher kann ein lokales, kleinflächiges Plasma 3 erzeugt werden.

Als Inertgas kann beispielsweise Stickstoff (N₂), Argon (Ar), oder Kohlendioxid (CO₂) eingesetzt werden. Da das Inertgas oder Gasgemisch unter Druck die Düse 1.1 verlässt, ist die Dichte des Gases oder des Gasgemisches im ringförmigen Bereich rund um die Elektrode oder Linse 7 höher als im Bereich genau vor der Elektrode 2 oder Linse 7. Je dichter ein Gas ist, desto mehr Energie wird benötigt, um dieses zu ionisieren. Zusätzlich werden durch den Gasstrom Ionen und Elektronen weggespült. Auch diese beiden Effekte tragen dazu bei, dass das Plasma 3 lokal begrenzt wird. Vor allem bei der Anwendung mit dem Laserstrahl 6 als Energiequelle kann als Gasgemisch Druckluft ausreichend sein, da beim durch Laser erzeugten Plasma 3 der Effekt der Sublimation gegenüber der Oxidation überwiegt.

## Patentansprüche

1. Verfahren zur Plasmaperforation von Tippingpapier (4), wobei an der Oberfläche des Tippingpapiers (4) ein Niedertemperaturplasma (3) erzeugt wird indem ein ionisierbares Gasgemisch durch eine möglichst punktförmige Energiequelle kurzzeitig ionisiert wird, **dadurch gekennzeichnet, dass** ein unter Druck stehendes Inertgas oder ein Gasgemisch mit hoher Inertgaskonzentration ringförmig um die Energiequelle in Richtung des Tippingpapiers (4) eingebracht wird, wodurch das ionisierbare Gasgemisch auf einen sehr kleinen Oberflächenbereich des Tippingpapiers (4) vor der Energiequelle örtlich beschränkt wird, indem dieser Bereich von einem Gasgemisch mit höherer Inertgaskonzentration ringförmig umgeben wird.

2. Verfahren nach Anspruch 1, **dadurch gekennzeichnet, dass** das unter Druck stehende Inertgas oder ein Gasgemisch mit hoher Inertgaskonzentration aus einer Düse (1.1) in Richtung des Tippingpapiers (4) ausströmt, wobei die Spitze der Energiequelle konzentrisch in der Düse (1.1) angebracht ist und vom Inertgas umströmt wird und die Ausbreitung des Gases oder Gasgemisches über den Öffnungsdurchmesser der Düse (1.1) und/oder über den Abstand der Öffnungsfläche der Düse (1.1) zur Spitze der Energiequelle eingestellt wird.

3. Verfahren nach Anspruch 1 oder 2, **dadurch gekennzeichnet, dass** die Energiequelle durch zwei zueinander beabstandete Elektroden (2, 5) gebildet wird, wobei sich im Spalt zwischen den beiden Elektroden (2, 5) das Tippingpapier (4) und das ionisierbare Gasgemisch befinden und durch Anlegen einer Spannung zwischen den Elektroden (2,5) das ionisierbare Gasgemisch ionisiert wird.

4. Verfahren nach Anspruch 1 oder 2, **dadurch gekennzeichnet, dass** die Energiequelle ein Laserstrahl (6) ist, der von einer Seite her auf das Tippingpapier (4) gerichtet wird und dass sich das ionisierbare Gas oder Gasgemisch im Laserstrahl (6) befindet und von diesem ionisiert wird.

5. Vorrichtung zur Plasmaperforation von Tippingpapier (4) bei der eine Energiequelle auf das Tippingpapier (4) gerichtet ist und diese Energiequelle eine Spitze aufweist, von der aus ein Energiestrahl auf das Tippingpapier (4) gerichtet ist, **dadurch gekennzeichnet, dass** diese Energiequelle in einem Rohr (1) angebracht ist, an dessen dem Tippingpapier (4) zugewandten Ende eine Düse (1.1) angeordnet ist, die als Austrittsöffnung für ein unter Druck stehendes Inertgas oder Gasgemisch mit hoher Inertgaskonzentration dient, wobei die Energiequelle konzentrisch in der Öffnungsfläche der Düse (1.1) angeordnet ist.

6. Vorrichtung nach Anspruch 5, **dadurch gekennzeichnet, dass** die Spitze der Energiequelle aus der Öffnung der Düse (1.1) in Richtung des Tippingpapiers (4) hervorragt.

7. Vorrichtung nach einem der Ansprüche 5 und 6, **dadurch gekennzeichnet, dass** die Energiequelle eine Elektrode (2) ist und sich das Tippingpapier (4) zwischen der Elektrode (2) und einer Gegenelektrode (5) befindet.

8. Vorrichtung nach Anspruch 7, **dadurch gekennzeichnet, dass** beide Elektroden (2, 5) nadelförmig sind.

9. Vorrichtung nach Anspruch 7, **dadurch gekennzeichnet, dass** eine nadelförmige Elektrode (2) und eine flächige Gegenelektrode (5) vorhanden sind.

10. Vorrichtung nach einem der Ansprüche 5 und 6, **dadurch gekennzeichnet, dass** die Energiequelle ein Laserstrahl (6) ist, der von einer Seite her auf das Tippingpapier (4) gerichtet ist und die Spitze der Energiequelle durch eine Linse oder einen Lichtwellenleiter gebildet ist.

## Claims

1. Method for plasma perforation of tipping paper (4), low-temperature plasma (3) being generated on the surface of the tipping paper (4) by an ionizable gas mixture being ionized for a short time by an energy source that is as punctiform as possible, **characterized in that** a pressurized inert gas or a gas mixture having a high concentration of inert gas is placed annularly around the energy source in the direction of the tipping paper (4), as a result of which the ionizable gas mixture is localized to a very small surface region of the tipping paper (4) in front of the energy source by this region being annularly surrounded by a gas mixture having a higher concentration of inert gas.

2. Method according to claim 1, **characterized in that** the pressurized inert gas or a gas mixture having a high concentration of inert gas flows out of a nozzle (1.1) in the direction of the tipping paper (4), the tip of the energy source being concentrically mounted in the nozzle (1.1) and inert gas flowing around said tip, and the spread of the gas or gas mixture being set by means of the opening diameter of the nozzle (1.1) and/or by means of the spacing of the opening surface of the nozzle (1.1) from the tip of the energy source.

3. Method according to either claim 1 or claim 2, **characterized in that** the energy source is formed by two mutually spaced electrodes (2, 5), the tipping paper (4) and the ionizable gas mixture being located in the gap between the two electrodes (2, 5), and the ionizable gas mixture being ionized by applying a voltage between the electrodes (2, 5).

4. Method according to either claim 1 or claim 2, **characterized in that** the energy source is a laser beam (6) which is directed from one side towards the tipping paper (4) and **in that** the ionizable gas or gas mixture is located in the laser beam (6) and is ionized thereby.

5. Device for plasma perforation of tipping paper (4), in which an energy source is directed towards the tipping paper (4) and said energy source comprises a tip from which an energy beam is directed towards the tipping paper (4), **characterized in that** said energy source is mounted in a tube (1) on which a nozzle (1.1) is arranged at the end facing the tipping paper (4), which nozzle functions as an outlet opening for a pressurized inert gas or gas mixture having a high concentration of inert gas, the energy source being concentrically arranged in the opening surface of the nozzle (1.1).

6. Device according to claim 5, **characterized in that** the tip of the energy source protrudes out of the opening of the nozzle (1.1) in the direction of the tipping paper (4).

7. Device according to either claim 5 or claim 6, **characterized in that** the energy source is an electrode (2) and the tipping paper (4) is located between the electrode (2) and a counter electrode (5).

8. Device according to claim 7, **characterized in that** the two electrodes (2, 5) are needle-shaped.

9. Device according to claim 7, **characterized in that** a needle-shaped electrode (2) and a planar counter electrode (5) are provided.

10. Device according to either claim 5 or claim 6, **characterized in that** the energy source is a laser beam (6) which is directed from one side towards the tipping paper (4) and the tip of the energy source is formed by a lens or an optical waveguide.

## Revendications

1. Procédé pour la perforation au plasma de papier manchette (4), un plasma basse température (3) étant généré au niveau de la surface du papier manchette (4) par ionisation rapide d'un mélange gazeux ionisable au moyen d'une source d'énergie dont la forme se rapproche le plus possible d'un point, **caractérisé en ce qu'**un gaz inerte ou un mélange de gaz ayant une forte concentration en gaz inerte se trouvant sous pression est introduit de manière circulaire autour de la source d'énergie en direction du papier manchette (4), par lequel le mélange de gaz ionisable est limité localement avant la source d'énergie à une très petite zone de la surface du papier manchette (4), cette zone étant entourée en forme de cercle par un mélange de gaz ayant une forte concentration en gaz inerte.

2. Procédé selon la revendication 1, **caractérisé en ce que** le gaz inerte ou un mélange de gaz ayant une forte concentration en gaz inerte se trouvant sous pression est diffusé par une buse (1.1) en direction du papier manchette (4), la pointe de la source d'énergie étant placée de manière concentrique dans la buse (1.1) et entourée d'un flux de gaz inerte et la diffusion du gaz ou du mélange de gaz étant réglée par le diamètre d'ouverture de la buse (1.1) et/ou par la distance entre la zone d'ouverture de la buse (1.1) et la pointe de la source d'énergie.

3. Procédé selon la revendication 1 ou 2, **caractérisé en ce que** la source d'énergie est formée par deux électrodes (2, 5) espacées l'une de l'autre, le papier manchette (4) et le mélange de gaz ionisables se trouvant dans l'interstice entre les deux électrodes (2, 5) et le mélange de gaz ionisables étant ionisé par la génération d'une tension entre les électrodes (2, 5).

4. Procédé selon la revendication 1 ou 2, **caractérisé en ce que** la source d'énergie est un rayon laser (6) qui est dirigé sur le papier manchette (4) à partir d'un côté et **en ce que** le gaz ou mélange de gaz ionisable se trouve dans le rayon laser (6) et est ionisé par celui-ci.

5. Dispositif pour la perforation au plasma de papier manchette (4) dans lequel une source d'énergie est dirigée sur le papier manchette (4) et cette source d'énergie présente une pointe à partir de laquelle un rayon d'énergie est dirigé sur le papier manchette (4), **caractérisé en ce que** cette source d'énergie est placée dans un tube (1) sur l'extrémité orientée vers le papier manchette (4) duquel, une buse (1.1) est disposée, laquelle sert d'ouverture de sortie pour un gaz inerte ou mélange de gaz ayant une forte concentration en gaz inerte se trouvant sous pression, la source d'énergie étant disposée de manière concentrique dans la zone d'ouverture de la buse (1.1).

6. Dispositif selon la revendication 5, **caractérisé en ce que** la pointe de la source d'énergie fasse dépasse de l'ouverture de la buse (1.1) en direction du papier manchette (4).

7. Dispositif selon l'une des revendications 5 et 6, **caractérisé en ce que** la source d'énergie est une électrode (2) et que le papier manchette (4) se trouve entre l'électrode (2) et une contre-électrode (5).

8. Dispositif selon la revendication 7, **caractérisé en ce que** les deux électrodes (2, 5) sont en forme d'aiguille.

9. Dispositif selon la revendication 7, **caractérisé en ce qu'**il contient une électrode (2) en forme d'aiguille et une contre-électrode (5) plate.

10. Dispositif selon l'une des revendications 5 et 6, **caractérisé en ce que** la source d'énergie est un rayon laser (6), qui est dirigé sur le papier manchette (4) à partir d'un côté et que la pointe de la source d'énergie est formée par une lentille ou un guide d'ondes lumineuses.
